**Europäisches Patentamt**

**European Patent Office**

**Office européen des brevets**

(19)

(11) Veröffentlichungsnummer: **0 080 169**
A2

## (12) EUROPÄISCHE PATENTANMELDUNG

(21) Anmeldenummer: **82110652.3**

(22) Anmeldetag: **18.11.82**

(51) Int. Cl.³: **H 05 K 3/02**, H 05 K 3/20

(30) Priorität: **19.11.81 DE 3145721**

(43) Veröffentlichungstag der Anmeldung: **01.06.83**
**Patentblatt 83/22**

(84) Benannte Vertragsstaaten: **AT BE CH FR GB IT LI LU NL SE**

(71) Anmelder: **Schmoock, Helmuth, Büchener Weg 121, D-2058 Lauenburg/Elbe (DE)**

(72) Erfinder: **Schmoock, Helmuth, Büchener Weg 121, D-2058 Lauenburg/Elbe (DE)**

(74) Vertreter: **Heldt, Gert, Dr. Dipl.-Ing., Neuer Wall 57 IV, D-2000 Hamburg 36 (DE)**

(54) **Verfahren zum Herstellen von gedruckten Schaltungen.**

(57) Verfahren zur Herstellung von gedruckten Schaltungen, die auf einer nicht leitenden Platte aufgetragen sind. Die Schaltungen werden von Leiterbahnen gebildet, die als Verstärkung an bestimmten Stellen auf eine die nicht leitende Platte bedeckende Metallschicht aufgetragen sind. Zwischen den Leiterbahnen ist die Metallschicht während der Auftragung der Leiterbahnen mit einer Abdeckschicht abgedeckt, die nach der Auftragung der Leiterbahnen von der Metallschicht wieder abgelöst wird. Sodann wird die zwischen den Leiterbahnen liegende Metallschicht in einem metallösenden Bad abgeätzt. Die Abdeckschicht kann auf die Metallschicht aufgedruckt werden. Für das Auftragen der Leiterbahnen stehen chemische oder elektrogalvanische Bäder zur Verfügung. Die Metallschicht kann auf eine Trägerfolie aufgebracht werden, von der sie mit der der Trägerfolie abgewandten Seite auf die nicht leitende Platte übertragen wird. Sodann wird die Trägerfolie von der Metallschicht abgelöst. Die Metallschicht kann auf ihren Untergrund aufgedampft werden.

Verfahren zum Herstellen von gedruckten Schaltungen

0080169

- 1 -

Die Erfindung betrifft ein Verfahren zum Herstellen von gedruckten Schaltungen, die auf einer nicht leitenden Platte aufgetragen sind, auf der über einen Haftvermittler Leiterbahnen haften.

Ein derartiges Verfahren ist bekannt und hat inzwischen sein Versuchsstadium soweit durchschritten, daß mit der Serienfertigung von Schaltungen begonnen werden kann. Bei der Durchführung der Versuche hat sich ergeben, daß in gewissen Anwendungsfällen eine andere Reihenfolge bei den einzelnen Fertigungsschritten eingehalten werden sollte.

Aufgabe der vorliegenden Erfindung ist es daher, das Verfahren der einleitend genannten Art so zu verändern, daß es auf alle Kombinationen von denkbaren Materialien anwendbar ist.

Diese Aufgabe wird erfindungsgemäß dadurch gelöst, daß die Leiterbahnen auf eine Metallschicht aufgetragen werden, die zwischen den Leiterbahnen mit einer eine Metallisierung verhindernden Abdeckschicht abgedeckt wird und daß nach vollzogener Verstärkung der Leiterbahnen die Abdeckschicht abgelöst und die dann frei werdende Metallschicht in einem metallösenden Bad abgeätzt wird.

Durch dieses Verfahren wird mit Hilfe des metalllösenden Bades eine genaue Abätzung der Teile der Metallschicht herbeigeführt, die zwischen den einzelnen Leiterbahnen liegt. Unbeabsichtigte Kontakte zwischen den Leiterbahnen durch stehengebliebene Reste der Metallschicht sind undenkbar. Zwar gehen im metallösenden Bad möglicherweise auch extrem dünne Anteile der Leiterbahnen wieder in Lösung. Die Leiterbahnen können aber vor dem Eintritt in das metallösende Bad so dick aufgetragen werden, daß ein geringes Ablösen der Leiterbahnen im metallösenden Bad die Funktionsfähigkeit der Leiterbahnen nicht stört. Das Verfahren läuft trotzdem schnell und relativ billig ab, da das Aufgalvanisieren bzw. chemische Reduzieren der Leiterbahnen auf die Metallschicht mit geringen Energiemengen schnell vollzogen werden kann.

Gemäß einer bevorzugten Ausführungsform der Erfindung wird die Platte zunächst vollflächig mit Haftvermittler überzogen, die Metallschicht vollflächig mit dem Haftvermittler verbunden, die Trägerfolie entfernt und auf die Metallschicht werden auf ihrer dem Haftvermittler abgewandten Seite die Leiterbahnen durch die Ablagerungen von Verstärkungen aufgetragen. Auf diese Weise findet zunächst die Übertragung der Metallschicht auf die Platte statt. Die Metallschicht ist daher im Zusammenhang mit der Platte relativ leicht zu handhaben, wenn die Leiterbahnen auf die Metallschicht aufgebracht und anschließend die Metallschicht zwischen den Leiterbahnen abgelöst wird. Außerdem ist auch schon die Ablösung der Trägerfolie von der Metallschicht vor dem Auftragen der Leiterbahnen erfolgt, so daß nicht die Gefahr besteht, daß einzelne Teile sowohl der Metallschicht als auch der Leiterbahnen durch das Abziehen der Trägerfolie beschädigt werden.

Gemäß einer weiteren Ausführungsform der Erfindung wird die Metallschicht auf ihrer von der Trägerfolie abgewandten Seite durch die Ablagerung von Verstärkungen mit Leiterbahnen versehen und die mit den Leiterbahnen versehene Seite der Metallschicht auf die nicht leitende Platte geklebt, worauf die Trägerfolie von der Metallschicht abgezogen wird.

In diesem Falle erfolgt die Auftragung der Leiterbahnen auf die Metallschicht zu einem Zeitpunkt, an dem die Metallschicht noch auf der Trägerfolie haftet. In diesem Zustand kann insbesondere auf leichte Weise eine Großserienfertigung durchgeführt werden, bei der in aufeinanderfolgenden Verfahrensstationen die Trägerfolie zunächst die Bedampfungsstation durchläuft, in der sie mit der Metallschicht bedampft wird. Sodann durchläuft die bedampfte Trägerfolie die Station, in der die Leiterbahnen aufgetragen werden. Zu diesem Zwecke werden die zwischen den Leiterbahnen liegenden Teile der Metallschicht abgedeckt. Die nicht abgedeckten Teile der Metallschicht werden durch Ablagerung von Metall beispielsweise im Galvanisierungsbad verstärkt.

Anschließend wird der auf die Trägerfolie aufgebrachte Schichtstoff mit seiner Metallseite auf die einzelnen Platten aufgeklebt und erst dann die Trägerfolie von der Metallschicht getrennt. Die einzelnen mit der Metallschicht versehenen Platten wandern durch das Ablösebad. Das die Ablösung herbeiführende Bad erreicht besonders gut die der Platte abgewandte Metallschicht und ätzt diese dünne Metallschicht bis auf die verstärkten Leiterbahnen ohne Schwierigkeiten ab. Da die Metallschicht auf der der Platte abgewandten Seite der Leiterbahnen haftet, wird sie von dem Metall ablösenden Bad leicht erreicht, so daß die Platten nur kurzzeitig in dem Bad verbleiben müssen.

Weitere Einzelheiten der Erfindung ergeben sich aus der nachfolgenden ausführlichen Beschreibung und den beigefügten Zeichnungen, in denen eine bevorzugte Ausführungsform der Erfindung beispielsweise veranschaulicht ist.

In den Zeichnungen zeigen:

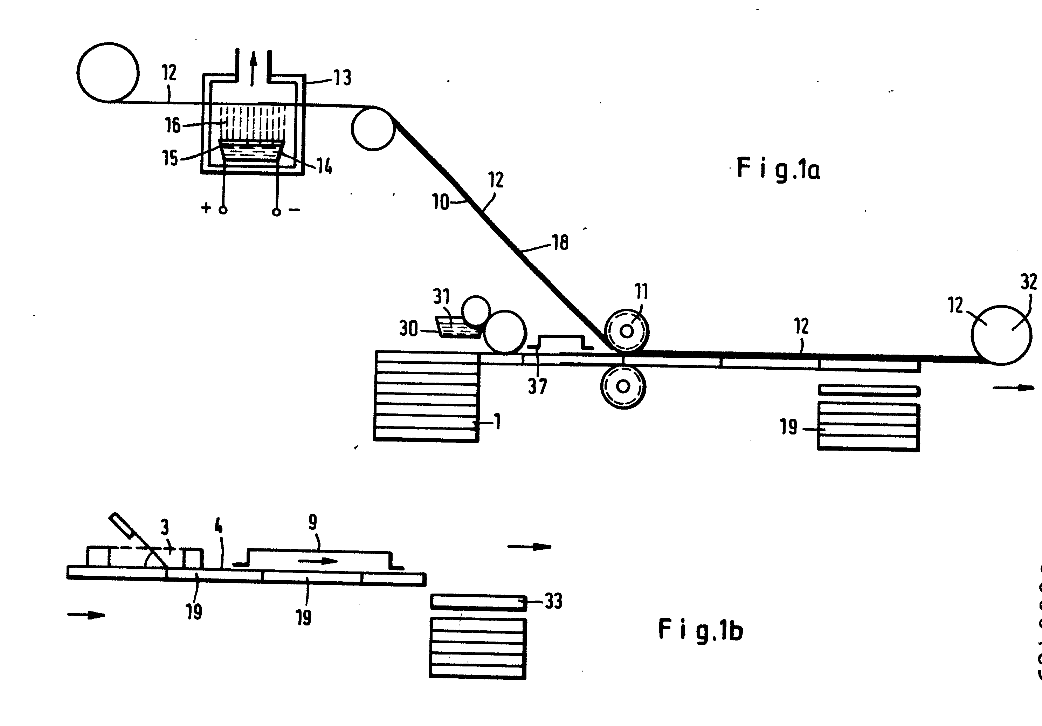

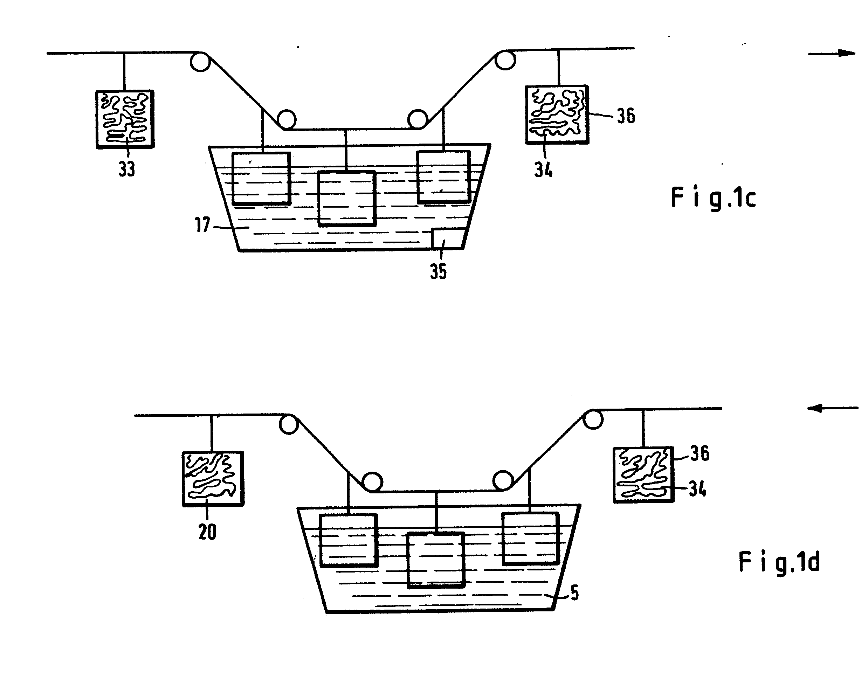

Fig. 1 a:  Eine schematische Darstellung eines Teils einer Anlage zur Herstellung von gedruckten Schaltungen,

Fig. 1 b:  eine schematische Darstellung eines weiteren Teils einer Anlage zur Herstellung von gedruckten Schaltungen,

Fig. 1 c:  eine schematische Darstellung eines weiteren Teils einer Anlage zur Herstellung von gedruckten Schaltungen,

Fig. 1 d:  eine schematische Darstellung eines letzten Teils einer Anlage zur Herstellung von gedruckten Schaltungen,

Fig. 2 a:  eine schematische Darstellung eines ersten Teils einer anderen Anlage zur Herstellung von gedruckten Schaltungen,

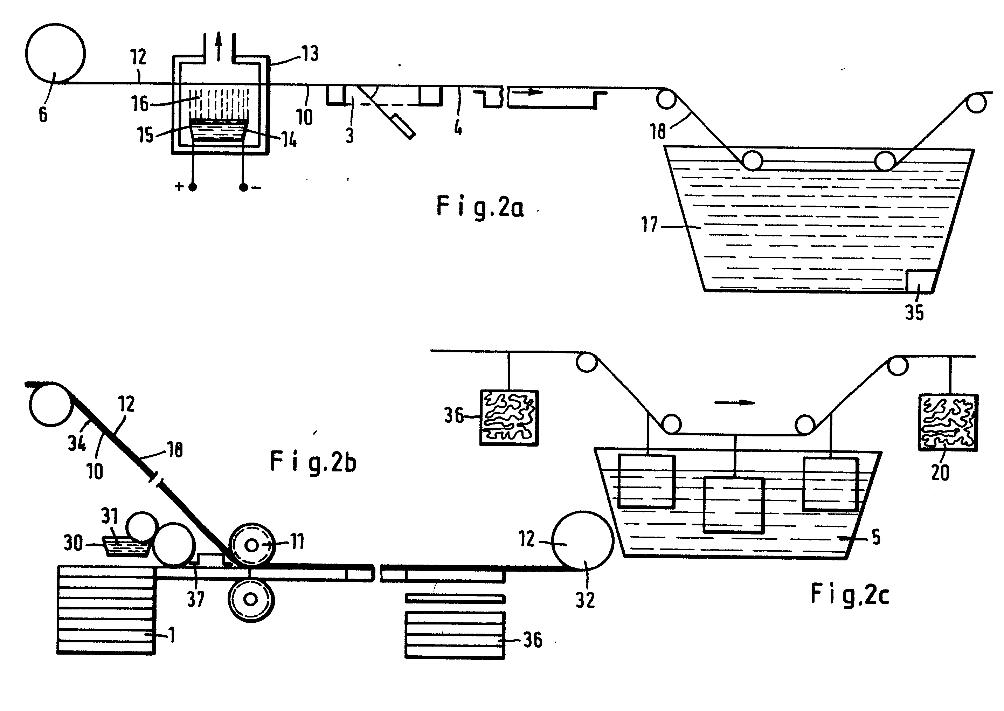

Fig. 2 b:  eine schematische Darstellung eines zweiten Teils dieser Anlage zur Herstellung von gedruckten Schaltungen und

Fig. 2 c:  eine schematische Darstellung eines dritten Teils dieser Anlage zur Herstellung von gedruckten Schaltungen.

Das erfindungsgemäße Verfahren wird zweckmäßigerweise auf Anlagen durchgeführt, die nach dem Schema der Gesamtfigur 1 oder nach dem Schema der Gesamtfigur 2 arbeiten. In einem Vorratsbehälter ist Material 1, insbesondere Platten in einem Stapel untergebracht, auf das Leiterbahnen zum Zwecke der Herstellung gedruckter Schaltungen aufgebracht werden sollen. Statt Platten kann auch rollbares Material 1 verwendet werden.

Das Material 1 wird auf seiner Oberfläche in einem Lackierwerk 30 mit Kleber 31 vollflächig beschichtet. Der Kleber 31 wird in einer Trockenstation 37 getrocknet. Sodann wandert das Material 1 in Richtung auf eine Walzenkombination 11, die eine Schichtstoffkombination 18 auf die mit dem Kleber 31 beschichtete Oberfläche des Materials preßt. Die Schichtstoffkombination 18 besteht aus einem Träger 12 und einer Metallschicht 10, die in einer Bedampfungskammer 13 auf den Träger 12 gedampft wird. Zu diesem Zwecke ist in dieser Bedampfungskammer 13 eine Heizung 14 vorgesehen, die ein Metallbad 15 so hoch erhitzt, daß unter dem Einfluß eines in der Bedampfungskammer 13 herrschenden Vakuums Metalldampf 16 in Richtung auf den durch die Bedampfungsstation 13 hindurchlaufenden Träger 12 aufsteigen und sich an diesem niederschlagen kann.

Die auf diese Weise hergestellte Schichtstoffkombination 18 verklebt mit ihrer metallisierten Seite vollflächig mit der mit dem getrockneten Kleber 30 bestrichenen Oberfläche des Materials 1. Die Walzenkombination 11 kann zu diesem Zwecke beheizt sein.

In dem Verbund von Material 1 mit der Schichtstoffkombination 18 polymerisiert der Kleber 30 aus, nachdem er mit Hilfe der Walzenkombination 11 verpreßt worden ist. Nach dem Aushärten haftet die Metallschicht 10 vollflächig fest auf der mit dem Kleber 30 beschichteten Oberfläche des Materials 1. Diese Haftung ist so fest, daß der Träger 12 von der Metallschicht 10 mit Hilfe einer Aufwickelrolle 32 abgetrennt werden kann, ohne daß sich die Metallschicht von der Oberfläche des Materials 1 löst. Die Adhäsion der Metallschicht 10 auf dem Kleber 30 ist viel größer als die Adhäsion des Metalls auf dem Träger 12. Auf diese Weise entstehen als Rohlinge mit einer vollflächigen Metallschicht versehene Platten.

Diese Rohlinge 19 werden in einem Druckwerk 3 mit einer Abdeckschicht 4 bedruckt. Dabei ist die Anwendung des Siebdruckverfahrens oder des Tiefdruckes möglich. Die Abdeckschicht 4 erstreckt sich über sämtliche Teile der metallisierten Oberfläche der Rohlinge 19, die zwischen den beabsichtigten Leiterbahnen liegen. Der Verlauf der zukünftigen Leiterbahnen wird hingegen mit dieser Abdeckschicht 4 nicht versehen. Nach dem Durchlaufen des Druckwerkes 3 wird die auf die Metallschicht aufgedruckte Abdeckschicht 4 je nach der Art des für die Herstellung der Abdeckschicht 4 verwendeten Materials in einer Trockenstation 9 getrocknet. Im Regelfall werden zur Herstellung der Abdeckschicht 4 Lacke verwendet, die möglicherweise auch trocknen, ohne daß sie eine Trockenstation 9 durchlaufen. Nach dem Verlassen der Trockenstation 9 sind aus den Rohlingen 19 bedruckte Rohlinge 33 entstanden,

0080169

auf die nunmehr Leiterbahnen 34 aufgalvanisiert werden. Zu diesem Zwecke werden die bedruckten Rohlinge 33 durch ein Metallisierungsbad 17 geleitet, in dem eine chemische Metallisierung der auf die Oberfläche des Materials 1 aufgebrachten Metallschicht stattfindet. Diese Metallisierung kann beispielsweise in Form einer elektrolytischen Galvanisierung vorgenommen werden. Zu diesem Zwecke besteht das Metallisierungsbad 17 aus einer elektrisch leitenden Flüssigkeit, in der Metallionen von einem entsprechenden Metallvorrat 35 unter dem Einfluß der elektrischen Spannung, die an die Rohlinge 33 angelegt ist, in Richtung auf die zu metallisierende Metallschicht wandern und sich dort an den nicht von der Abdeckschicht 4 abgedeckten Stellen ablagern.

Die Durchtrittsgeschwindigkeit der bedruckten Rohlinge 33 durch das Metallisierungsbad 17 hängt ab von dem jeweils gewählten Metall, der zwischen dem Metallvorrat 35 und der an die Metallschicht der bedruckten Rohlinge angelegten Spannung, der für das Metallisierungsbad 17 festgelegten Flüssigkeit sowie der Geschwindigkeit, mit denen die bedruckten Rohlinge 33 durch das Metallisierungsbad 17 wandern. Nach dem Verlassen des Metallisierungsbades 17 ist auf die nicht mit der Abdeckschicht 4 versehenen Teile der auf die Oberfläche des Materials 1 aufgetragenen Metallschicht Metall abgelagert worden, das die Leiterbahnen 34 bildet. Diese Leiterbahnen 34 sind allerdings noch durch die sich unterhalb der Abdeckschicht 4 befindlichen Teile der Metallschicht 10 miteinander verbunden. Sie bilden beschichtete Rohlinge 36, von denen die zwischen den Leiterbahnen 34 liegenden Teile der Metallschicht 10 entfernt werden müssen.

0080169

Zu diesem Zwecke werden die beschichteten Rohlinge 36 durch ein weiteres Bad 5 geleitet. In
diesem Bad wird die Abdeckschicht 4 von der Metallschicht und die Metallschicht von der Oberfläche des Materials 1 entfernt. Dabei geht auch
ein geringer Anteil des Metalls in Lösung, das
als Leiterbahnen 34 auf die Metallschicht aufgetragen worden war. Dieser Anteil ist aber so
gering, daß dadurch die Funktionsfähigkeit der
Leiterbahnen 34 nicht gestört wird, weil die
aufgedampfte Metallschicht 10, die lediglich
abgeätzt werden muß, sehr dünn ist. Der Verlust
an Material im Bereich der Leiterbahnen 34 durch
das Bad 5 ist beim Durchlaufen des Metallisierungsbades 17 bereits berücksichtigt worden.

Nach dem Verlassen des Bades 5 ist die die Leiterbahnen 34 untereinander verbindende Metallschicht beseitigt, so daß nunmehr nur noch die
Leiterbahnen 34 fest auf dem Material 1 haften.
In diesem Zustand ist die gedruckte Schaltung
für den Einsatz fertig.

Darüber hinaus kann das erfindungsgemäße Verfahren auch in einer Anlage durchgeführt werden,
die in der Gesamtfigur 2 dargestellt ist. Auch
bei diesem Verfahrungsablauf wird zunächst ein
auf einer Trägerrolle 6 angelieferter Träger
12 in einer Bedampfungsstation 13 mit einer Metallschicht 10 bedampft. Sodann wird die Metallschicht 10 im Druckwerk 3 bedruckt. Dabei wird
ähnlich wie beim vorbeschriebenen Verfahren eine
Abdeckschicht 4 auf die Metallschicht 10 aufgebracht. Diese Abdeckschicht 4 bedeckt die Metallschicht 10 an allen Stellen, an denen sich auf
der Metallschicht 10 keine Leiterbahnen 34 erstrecken sollen.

Die Abdeckschicht 4 kann in einer Trockenstation 9 getrocknet werden. Die Trockenstation kann jedoch auch je nach der Auswahl des für die Abdeckschicht 4 ausgewählten Materials fehlen. Sodann wird der mit der Metallschicht und der Abdeckschicht 4 versehene Träger 12 als Schichtstoffkombination 18 durch das Metallisierungsbad 17 geleitet. Dabei werden im Bereich der zwischen der Abdeckschicht 4 liegenden Teile der Metallschicht 10 Metallionen auf die Metallschicht 10 aufgetragen, die unter dem Einfluß der für den Einzelfall festzulegenden elektrischen Spannung vom Metallvorrat 35 in Richtung auf die zwischen der Abdeckschicht 4 liegenden Teile der Metallschicht 10 wandern. Nach dem Verlassen des Metallisierungsbades 17 sind auf der Metallschicht 10 die Leiterbahnen 34 vorhanden. In diesem Zustand wandert die Schichtstoffkombination 18 in Richtung auf die Walzenkombination 11, in die gleichzeitig das Material 1 einmündet.

Das Material 1 ist auf seiner für die Aufnahme der Schichtstoffkombination 18 vorgesehenen Oberfläche mit Kleber 31 beschichtet, der auf die Oberfläche vom Lackierwerk 30 aufgetragen wird. Der Kleber 31 wird in der Trockenstation 37 getrocknet. In der Walzenkombination 11 wird die mit den Leiterbahnen 34 versehene Metallschicht 10 auf den Kleber 31 gepreßt, so daß sie fest mit dem Material 1 verklebt. Nunmehr kann der Träger 12 von der Metallschicht 10 abgelöst und auf eine Aufwickelrolle 32 aufgewickelt werden. Auf diese Weise sind beschichtete Rohlinge 36 entstanden, bei denen allerdings zwischen den Leiterbahnen 34 noch Teile der Metallschicht 10 vorhanden sind. Diese Teile der Metallschicht 10 werden im Bad 5 abgelöst, durch die die beschichteten Rohlinge 36 hindurchgeleitet werden. Dabei kann sowohl die Metallschicht 10, die zwischen den Leiterbahnen 34 liegt, als auch die Abdeckschicht 4 in Lösung gehen. Für den Verwendungszweck der Leiterplatten reicht es jedoch aus, wenn nur die Metallschicht 10 zwischen den Leiterbahnen 34 entfernt wird. Nach dem Durchlaufen des Bades 15 ist eine fertige Leiterplatte 20 entstanden, die für den vorgesehenen Zweck eingesetzt werden kann.

Die beiden beschriebenen erfindungsgemäßen Verfahren sind in ihrer Wirkungsweise unabhängig von den verwendeten Materialien 1, von den Metallen für die Metallschicht 10, von den verwendeten Klebern 31 und den eingesetzten Bädern 5 bzw. Metallisierungsbädern 17. Darüber hinaus ist es möglich, den Kleber 31 nicht auf das Material 1, sondern statt dessen auf die Metallschicht 10 aufzufahren. Schließlich ist der Erfolg der erfindungsgemäßen Verfahren unabhängig davon, ob die Rohlinge 19, die bedruckten Rohlinge 33 bzw. die beschichteten Rohlinge 36 in der angegebenen Weise zwischengelagert werden oder unmittelbar nach Abschluß der jeweiligen Fertigungsverfahren unmittelbar in die weitere Fertigung einbezogen werden.

- 11 -

Patentansprüche:

1. Verfahren zum Herstellen von gedruckten Schaltungen, die auf einer nicht leitenden Platte aufgetragen sind, auf der über einen Haftvermittler Leiterbahnen haften, dadurch gekennzeichnet, daß die Leiterbahnen (34) auf einer Metallschicht (10) als Verstärkung aufgetragen werden, die zwischen den Leiterbahnen (34) mit einer eine Metallisierung verhindernden Abdeckschicht (4) abgedeckt wird, und daß nach vollzogener Verstärkung der Leiterbahnen (34) die Abdeckschicht (4) abgelöst und die dann frei werdende Metallschicht (10) in einem metallösenden Bad (5) abgeätzt wird.

2. Verfahren nach Anspruch 1, dadurch gekennzeichnet, daß die Abdeckschicht (4) auf die Metallschicht (10) aufgedruckt wird.

3. Verfahren nach Anspruch 1 und 2, dadurch gekennzeichnet, daß die Abdeckschicht (4) auf die Metallschicht (10) im Siebdruckverfahren aufgebracht wird.

4. Verfahren nach Anspruch 1 und 2, dadurch gekennzeichnet, daß die Abdeckschicht (4) auf die Metallschicht (10) im fotografischen Verfahren aufgebracht wird.

5. Verfahren nach Anspruch 1 bis 4, dadurch gekennzeichnet, daß die Leiterbahnen (34) auf die Metallschicht (10) elektrisch aufgalvanisiert werden.

0080169

- 12 -

6. Verfahren nach Anspruch 1 bis 4, dadurch gekennzeichnet, daß die Leiterbahnen (34) durch chemische Reduktion auf die Metallschicht (10) aufgebracht werden.

7. Verfahren nach Anspruch 1 bis 6, dadurch gekennzeichnet, daß die Metallschicht (10) auf eine Trägerfolie (12) aufgebracht wird und die Metallschicht (10) mit ihrer der Trägerfolie (12) abgewandten Seite über einen Haftvermittler auf eine nicht leitende Platte aufgebracht wird und die Trägerfolie (12) nach dem Ankleben der Metallschicht (10) von dieser abgelöst wird.

8. Verfahren nach Anspruch 1 bis 7, dadurch gekennzeichnet, daß auf die Trägerfolie (12) vor dem Auftragen der Metallschicht (10) eine Ablöseschicht aufgebracht wird, auf die die Metallschicht (10) aufgedampft wird.

9. Verfahren nach Anspruch 1 bis 8, dadurch gekennzeichnet, daß die Metallschicht (10) auf ihren Untergrund aufgedampft wird.

10. Verfahren nach Anspruch 1 bis 9, dadurch gekennzeichnet, daß der Haftvermittler auf die nicht leitende Platte aufgebracht wird.

11. Verfahren nach Anspruch 1 bis 9, dadurch gekennzeichnet, daß der Haftvermittler auf die Metallschicht (10) aufgetragen wird.

12. Verfahren nach Anspruch 1 bis 11, dadurch gekennzeichnet, daß die Metallschicht (10) vor der Auftragung der Leiterbahnen (34) auf die Platte geklebt wird.

13. Verfahren nach Anspruch 1 bis 12, dadurch gekennzeichnet, daß die Platte vollflächig mit Haftvermittler überzogen wird, die Metallschicht (10) vollflächig mit dem Haftvermittler verbunden wird, die Trägerfolie (12) entfernt wird und auf die Metallschicht (10) auf ihrer dem Haftvermittler abgewandten Seite die Leiterbahnen (34) durch Ablagerungen von Verstärkungen aufgetragen werden.

14. Verfahren nach Anspruch 1 bis 11, dadurch gekennzeichnet, daß die Metallschicht (10) auf ihrer von der Trägerfolie (12) abgewandten Seite durch die Ablagerungen von Verstärkungen mit Leiterbahnen (34) versehen wird und daß die mit den Leiterbahnen (34) versehene Seite der Metallschicht (10) auf die nicht leitende Platte geklebt und die Trägerfolie (12) von der Metallschicht (10) abgezogen wird.

Fig.1a

Fig.1b

Fig.1c

Fig.1d

Fig.2a

Fig.2b

Fig.2c